# EUROPEAN PATENT SPECIFICATION

(11) **EP 3 362 806 B1**
(45) Date of publication and mention of the grant of the patent: **18.05.2022**
(21) Application number: 16791690.7
(22) Date of filing: 11.10.2016
(51) Int. Cl.: G01R 31/68, G01R 27/14

(54) **METHOD AND APPARATUS FOR CARRYING OUT TESTING OF AN ELECTRICAL CONTACT AND/OR OF AN ELECTRICAL CONNECTION**
VERFAHREN UND VORRICHTUNG ZUR DURCHFÜHRUNG DER PRÜFUNG EINES ELEKTRISCHEN KONTAKTES UND/ODER EINER ELEKTRISCHEN VERBINDUNG
PROCÉDÉ ET APPAREIL DESTINÉS À EFFECTUER UN TEST SUR UN CONTACT ÉLECTRIQUE ET/OU UNE CONNEXION ÉLECTRIQUE

(30) Priority: 13.10.2015 IT UB20154637
(43) Date of publication of application: 22.08.2018
(73) Proprietor: ROSA MICRO S.R.L., 33080 Porcia (PN) (IT)
(72) Inventor: ZULIANELLO, Mauro, 30020 Eraclea (VE) (IT)
(74) Representative: Giugni, Valter
(86) International application number: PCT/IB2016/056076
(87) International publication number: WO 2017/064617

(56) References cited:
- DE-A1- 3 711 593
- GB-A- 1 141 904
- US-A1- 2012 106 591

## Description

### AMENDED DESCRIPTION (clean copy)

### TECHNICAL FIELD OF THE INVENTION

The present invention is related to a method for carrying out testing of an electrical contact and/or of an electrical connection. In particular the present invention is related to a method for carrying out an electrical test to be used in a non-destructive way for the evaluation of new electrical contacts or for their maintenance, preferably in the industrial sector.

Generally the invention can be used to test electrical contacts and can be applied in a great number of situations where it is necessary or convenient to test the efficiency of one or more electrical contacts.

An example of an electrical contact is represented by the union of a socket and a plug to allow the transmission of electrical energy through them or in general the permanent or non permanent coupling of two or more conductors ensuring electrical continuity. Hereinafter it will be referred to electrical contacts also analogously comprising electrical connections, such as electrowelded or riveted contacts for the transmission of electrical energy or in general the coupling of two or more terminals that can be either fixed or mobile between them such as a switch.

### PRIOR ART TECHNIQUE

The principal known methods, preferably in the industrial sector, used to evaluate the correct operation of electrical apparatuses, in general, can be divided into the so-called "type test", "routine test", internal quality tests and many more.

A type test generally tests a sample selected from the totality of the electrical apparatuses to be tested, carrying out the type test on each element of the sample. It might happen that a type test is of a destructive type, that is it might make the electrical apparatus useless after the test has been performed. Furthermore, type tests must be in compliance with the regulations necessary for validation.

A routine test allows to evaluate the totality of electrical apparatuses produced, usually using non-destructive tests, so as to be able to use it for example to test an entire production batch in the industrial sector.

These testing methods generally employ measuring equipment that, making use of some known electrical laws, stimulate each electrical apparatus monitoring its behaviour with time. If their behaviour deviates from the generally accepted behaviour, the electrical apparatus is evaluated as flawed/not compliant and/or it is subjected to subsequent more exhaustive tests.

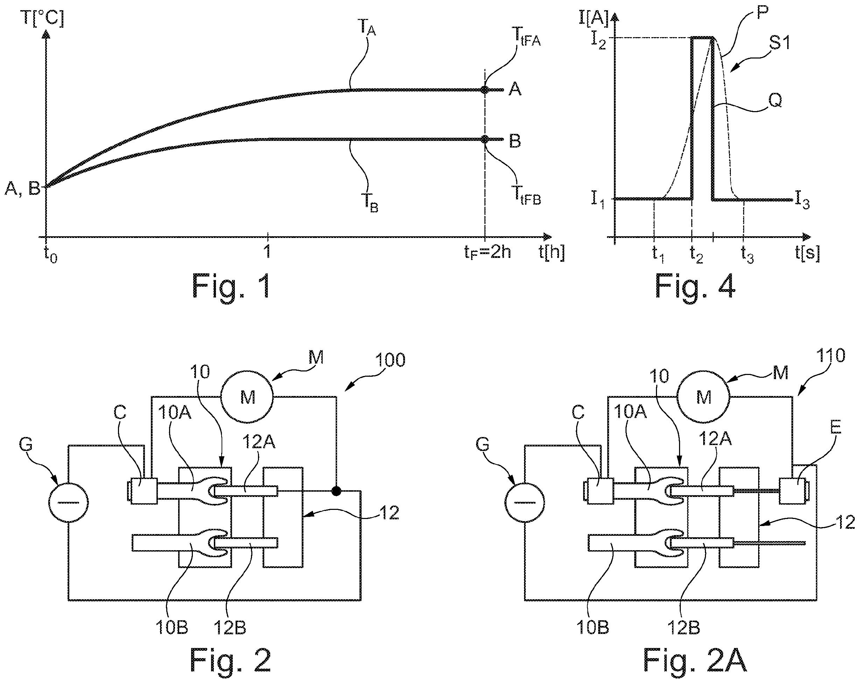

An example of a potentially destructive type test, in the sector of electrical contacts is the temperature test, an example of which is shown in figure 1. In such test it is evaluated the temperature of the elements that make up the electrical contact, in the example two contacts A and B present in a socket, while the same is subjected to electrical loads correlated to the value of the nominal power for which they have been realized, starting from the initial time t0, until reaching the final time tF, for example after two hours, when the temperature proves to be stabilized. Contact A, detected as flawed, shows a temperature curve TA that culminates at the temperature TtFA, therefore at a temperature higher than that reached by contact B detected as compliant which presents a temperature curve TB which culminates at the temperature TtFB. The final temperatures of the two contacts thus prove to be indicative of the compliance or not of the contact being tested. An example of temperature test is the CEI specification 23-50 article 19.

In such tests it is used the measurement of the temperature and its trend with time for each element of the electrical contact so as to compare it with the standard trends, for example by checking that an anomalous increase of the temperature, for example with respect to the ambient temperature, can be an indicator of a flawed element of the contact which then is not in compliance. These tests, carried out on samples, mainly need a longer time, for example hours to be performed, thus being incompatible with the time needed to evaluate the totality of an industrial production of electrical contacts.

Because of their nature temperature tests, or more precisely type tests, do not make it possible to re-use the tested component.

In the sector of civil sockets, another kind of type tests is the one called minimum extraction force test, wherein a single socket is evaluated as compliant if it is capable of keeping in place a plug attached to a weight that for gravity tends to extract it from the socket, otherwise it is discarded. It is therefore identified an acceptable threshold of holding force expressed by the electrical contact, evaluated as a mechanical performance. Furthermore, as it is mechanical such test cannot be integrated into an electrical apparatus performing other kinds of electrical tests on the electrical contact being tested.

GB 1141904 discloses the application to two contacting bodies of electrical pulses of constant or sequentially increasing known amplitude. A pulse of know amplitude and duration would be passed through the bodies and the potential drop would subsequently be measured again at a known current to detect any change caused by a change in the resistance of the circuit. The process of measurement and pulsing would continue until such a change was noted. At that point the amplitude of the specific pulse which first produced permanent change in the constriction resistance would be known.

DE 3711593 discloses a burner for locating cable faults. A device is disclosed for detecting cable faults by means of a pulse measuring device and with a DC high voltage source, which is applied to the cable to be tested, wherein the voltage is increased until an ignition occurs at the fault location in the cable. The pulse from the pulse echo meter pulse emanates to the cable start and metrologically evaluated, wherein three high-voltage stages are provided, each with stepwise rising higher output voltage, which are connected to the output side via coupling rectifier and at the input side to a switch abut, the center tap is applied to a further switch of a network-side variable transformer.

### SUMMARY OF THE INVENTION

The main task of the object of the present invention is that of overcoming the drawbacks of the prior art by devising a method for carrying out a test of one or more electrical contacts which is feasible in an electrical way.

Within the field of the foregoing task, an object of the present invention is that of devising an electrical test which is quick to perform.

A further object is that of providing a method for a test which is not destructive, maintaining in compliance the performances of adequate electrical contacts.

Still a further object is that of devising a method which potentially could be used as an internal quality test and/or as type test and/or as routine test in the sector of electrical contacts, and which would require simple equipment and a short time to be performed.

At first it has been studied an electrical test based on Joule's and Ohm's laws and on the variation of an electrical contact resistance due to a variation of its temperature so that its resistance increases in the presence of a flawed electrical contact since its temperature increases more compared to a compliant electrical contact, because of the trend of the temperature coefficient, as it will be described later.

The foregoing task and objects as well as others that will be described later, are reached by a method for carrying out a test of an electrical contact as defined by claim 1 and by an apparatus to carry out such method as defined by claim 14.

### BRIEF DESCRIPTION OF FIGURES

Further characteristics and advantages of the present invention will become more apparent from the following description of a particular but not excluding embodiment described for exemplification only but not limited to with reference to the appended drawings, wherein:
- Figure 1 shows a schematic view of the experimental trend of the temperature of the electrical contacts of a socket with time, while performing a test according to the known technique;
- Figures 2 and 2A each shows a schematic view of a wiring diagram, useful for carrying out the method according to the invention in order to test a socket comprising two electrical contacts, employed for one electrical contact at a time according to two embodiments of the invention;
- Figure 3 shows a schematic view of the expected resistance behaviour with time, according to the known technique, of each electrical contact of the socket shown in figure 2;
- Figure 4 shows a simplified and exemplary schematic view of two trends of the current to which an electrical contact is subjected according to two embodiments of the invention;
- Figure 5 shows a schematic view of the experimental behaviour of the resistance with time of each electrical contact of the socket shown in figure 2.

### DETAILED DESCRIPTION OF THE INVENTION

With reference to the above mentioned figures, a first flawed electrical contact has generally been designated with the reference letter A in the embodiment shown for exemplification only in the appended figures, whereas letter B designates a second compliant electrical contact, whose behaviour it is desired to analyse.

Hereinafter it is referred to electrical contacts formed by a connection between a socket 10 and a plug 12. The socket 10 comprises a first element 10A and a second element 10B and in turn, the plug 12 comprises a first coupling 12A and a second coupling 12B.

Each electrical coupling between an element of the socket 10 and a coupling of the plug 12 therefore forms an electrical contact that can be tested. For example in figure 2 a first electrical contact A comprises the first element 10A of the socket 10 and the first coupling 12A of the plug 12, while a second electrical contact B comprises the second element 10B of the socket 10 and a second coupling 12B of the plug 12.

Hereinafter it is described, with reference to figure 2, an exemplary wiring diagram which is useful for the application of the method according to a first embodiment of the invention, in order to test the electrical contacts A and B with respect to the plug 10.

Such wiring diagram can be integrated into an electrical apparatus to perform the method according to the invention.

As it can be seen in figure 2, the socket 10 is coupled to a compatible plug 12 in an electrical circuit 100 comprising an electric generator G and an electrical measuring device M such as multimeter, voltmeter, ammeter, ohmmeter, four-wire ohmmeter, Wheatstone bridge or the like.

The electric generator G is preferably a generator that allows to change the instantaneous electric power supplied to the electrical contact with time, for example varying the voltage or the current to which it is subjected. An example of an electric generator G is a voltage generator or a current generator or the like.

The socket 10 is coupled to the electric generator G and to the electrical measuring device M by means of a first terminal C which is coupled to the first element 10A of the same socket 10.

The electric circuit 100, as it can be seen in figure 2, is set so as to test an electrical contact at a time, in this specific example the first electrical contact A.

By means of the electric circuit 100 it is possible to test also the second element 10B of the socket 10, for example moving the first terminal C from the first element 10A to the second element 10B of the socket 10.

Subsequently, the plug 12 is extracted from the socket 10 and reintroduced upside down in the same socket 10, so that the first coupling 12A is coupled with the second element 10B of the socket 10 to form a second electrical contact B.

Such configuration shows to have the advantage of making it possible to evaluate the first element 10A and the second element 10B of the socket 10 when they are respectively coupled with the first coupling 12A of the plug 12 in two successive times. The evaluation of the respective electrical contacts formed will not therefore be affected by the variability between the first coupling 12A and the second coupling 12B of the plug 12, as the elements of the socket 10 are respectively coupled with the first coupling 12A of the plug 12 in successive time intervals.

Hereinafter it is described, with reference to figure 2A, a wiring diagram exemplifying an electric circuit 110, which is useful for the application of the method according to a second embodiment of the invention.

In the description of the electric circuit 110, are suitably kept the alphanumeric references of the elements of the electric circuit 100 previously described, when they are analogous to the corresponding elements of the same electric circuit 100.

The plug 12 is coupled to the electric generator G and to the electrical measuring device M by means of a second terminal E which is coupled to the first coupling 12A of the same plug 12. Such configuration allows to test an electrical contact A comprising the first element 10A and the first coupling 12A.

By means of the electric circuit 110 it is possible to test also the second element 10B of the socket 10, for example moving the first terminal C from the first element 10A to the second element 10B of the socket 10 and moving the second terminal E from the first coupling 12A to the second coupling 12B of the plug 12, so that the second coupling 12B is coupled to the second element 10B of the socket 10 to form a second electrical contact B.

Such wiring diagram 110 can suitably be integrated into an electrical apparatus to perform the method according to the invention.

Furthermore, the method can provide a test performed according to what previously described, employing the electric circuit 100, the electric circuit 110 or both combined, so as to make use of a greater number of significant data depending on the desired evaluation.

The wires used to connect the various elements of the electric circuit 100 and of the electric circuit 110 are appropriately dimensioned according to the values of the nominal current of the socket 10 and/or of the plug 12 or the respective nominal power.

Hereinafter it is reported the line of reasoning coherent with the electrical laws currently known, later described in detail, which has been at the root of the experimentation to achieve the present invention.

In fact, it has been hypothesised a method for testing electrical contacts which could be easily used as a quick test of electrical contacts, preferably testing the totality of the statistical population without just using only a sample chosen from the population.

It was thought to perform an electrical quality test, favouring the often already present tests which generally are of the electrical kind.

Taking into consideration a simple resistance measurement of the electrical contact and its evaluation with respect to an experimentally pre-set resistance threshold, even evaluated with accurate methods, for example with the four-wire method, such measurement has at least two drawbacks.

The first drawback is related to low values of resistance involved for this type of electrical contact, while the second drawback is that the variability whose presence might compromise the result. A resistance absolute value therefore seems a very little reliable parameter for testing the efficiency of an electrical contact.

It has therefore been hypothesised a method that envisages a differential measurement, described hereinafter.

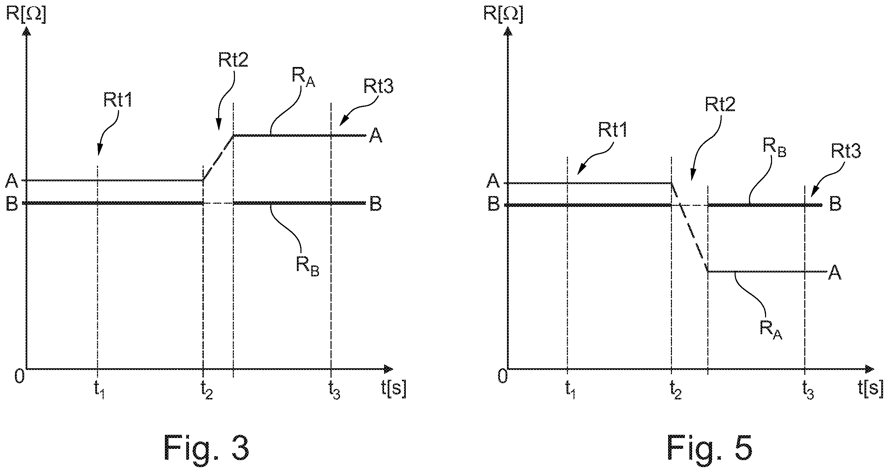

Therefore, the hypothesised method comprises the following steps, described with reference to figure 2 as regards the reference wiring diagram and to the hypothetical graph of figure 3, which represents a hypothetical trend of the resistance measured for the electrical contacts A and B of the socket 10, respectively tested individually.

The graph of figure 4 moreover shows two exemplary trends of the current applied to the socket 10 by means of the generator G in the electric circuit 100, which can be employed in order to perform the method according to the invention.

In a first time t1, for example after 2 seconds with respect to the beginning of the test, a first resistance Rt1 of the first electrical contact A in known ambient conditions and at a value of the first current l1, for example equal to the nominal current at which the socket 10 has been designed, is measured by means of the device M. An example of such measurement can be the measurement of a first voltage or voltage drop at the ends of the device M. Of course the times can vary depending on the equipment employed.

In a second time t2, for example equal to 5 seconds, the electrical contact is subjected to an electric stress S1 preferably for a short time. In fact, it is desired to apply a disturbance which will not cause significant increases of the temperature on the compliant electrical contacts, while on the contacts with problems, for the Joule's effect, it will be obtained an increase of the temperature such that it also increases the resistance of the same electrical contact due to the temperature coefficient. Consequently, it should be obtained an increase of the resistance at the ends of the electrical contacts which is significant and such that it allows an effective comparison with the first resistance Rt1 previously measured.

The behavioural hypothesis envisages that because of the Joule's effect it will be achieved the heating up of the electrical contact, witnessing therefore an increase of the temperature on the inadequate electrical contacts consequently also having a greater resistance due to the temperature coefficient on the inadequate electrical contacts. In fact, a similar behaviour is also observed in the temperature tests where it occurs that non-compliant electrical contacts heat up more than the compliant or adequate ones.

The electric stress S1 is a determined quantity of electric energy supplied to the electrical contact, obtained through a variation with time of the electric energy supplied to the same electrical contact. In other words the electric stress S1 is a predetermined variation of instantaneous electric power to which the electrical contact is subjected, said variation being maintained for a predetermined time interval.

Such variation causes the electrical contacts to be subjected, for a determined time interval, to an electric power greater than for example the electric power for which the electrical contact has been designed. This variation of electric power can be obtained with regard to the electrical contact by varying the voltage and/or the current intensity to which the same electrical contact is subjected.

Electric power is the electric work performed on electric charges inside the conducting material of the electrical contact by an electric field in the time unit, hereinafter also instantaneous electric power.

The electric stress S1 is for example a peak of current having an intensity peak equal to a second current 12, preferably greater than the first current l1. An example of current peak is shown in figure 4 by means of a dashed line and by the letter P.

The electric stress S1 is preferably a current pulse, having an adequate ramp, greater than the nominal current. Preferably the pulse intensity is higher than at least twice the nominal current, so as to adequately stress the electrical contact and thus obtain a significant and measurable variation. Of course, it is conveniently possible to refer to the nominal instantaneous electric power for which the electrical contact has been designed.

Furthermore, the electric stress S1 can be maintained for a substantially short time interval, preferably less than 2 seconds, so as to obtain a quick method of measurement. Of course, it is preferable to use shorter time intervals, for example less than 1 second or preferably less than tenths of a second or hundredths of a second, for example when allowed by the apparatuses used.

Preferably, the stress S1 can be a pulse having a substantially vertical ramp and even more preferably it can be a square wave pulse, so as to obtain sudden intensity variations and greater significance in the method application. An example of a square wave current pulse is shown in figure 4 by means of a continuous line and by the letter Q.

In a third time t3, for example 9 seconds, by means of the device M it is measured a third resistance Rt3 of the electrical contact A in known ambient conditions and at a third current 13, for example equal to the first current l1, so as to bring the current's conditions again to be similar to the first resistance measurement. An example of such measurement might be the measurement of a third voltage at the ends of the device M.

What one would expect then is that a problematic electrical contact has a more marked difference of behaviour with respect to a compliant electrical contact, as exemplified in the graph of figure 3, where it can be seen that the resistance of the first electrical contact A is hypothesised as having a much more marked increase with respect to the increase of the resistance of the second electrical contact B. Furthermore, according to the method, the electrical contact B substantially should maintain a constant resistance, so as to secure the electrical contacts that are compliant.

The expected result is therefore that the resistance differential between the third time t3 and the first time t1 is positive, since the resistance increases depending on the temperature coefficient, due to the heating for both electrical contacts, observing a greater resistance differential for inadequate electrical contacts.

Surprisingly, the experimental tests, as it can be seen in figure 5, have shown a behaviour even opposite to what hypothesised, achieving that at the ends of the inadequate first electrical contact A, the measured voltage in the third time t3 does not increase but decreases.

In other words, the resistance experimentally observed is constant or it slightly increases as regards compliant electrical contacts, while surprisingly it decreases for problematic or flawed electrical contacts.

The experimental tests have been carried out applying different failure modes that are typical of electrical contacts and with a relevant statistical significance it has been observed that for those electrical contacts having failure modes the resistance decreases because of the electrical stress applied as previously described.

An example of the data experimentally observed is the case of a socket comprising two electrical contacts, which has been tested by means of the testing method according to the invention with the following results.

At first, the same socket has been tested by means of a minimum extraction force test according to the reference specification CEI 23-50 article 22.2 obtaining the results which have identified the first electrical contact A as non compliant and the second electrical contact B as compliant, thus also diagnosing the failure mode, that is a weak mechanical tightness of the inner terminal corresponding to the first electrical contact A of the socket 10.

Subsequently, continuing the experimental tests of the method according to the invention, surprisingly the first electrical contact A of the tested socket showed a first voltage measured in the first time t1 of 43.16 mV and a third voltage, measured in the third time t3, equal to 41.00 mV obtaining a negative differential, equal to -2.16 mV. Taking the resistances into consideration, it can then be observed a first resistance RAt1 of 4.32 mΩ and a third resistance RAT3 of 4.10 mQ, obtaining a surprisingly negative differential of -0.22 mΩ.

In fact it has been employed a nominal current equal to 10 amperes for the first current l1 and for the third current 13, while the pulse relative to the second current l2 was equal to 100 amperes.

The second electrical contact B of the socket observed has shown a first voltage measured in a first time of 34.2 mV and a third voltage, measured in the third time, equal to 34.5 mV obtaining a positive differential, equal to 0.3mV. Taking the resistances into consideration, it can then be observed a first resistance RBt1 of 3.42 mΩ and a third resistance RBt3 of 3.45 mΩ, obtaining a substantially null differential of 0.03 mΩ.

According to these results the first electrical contact A would be potentially inadequate, while the second electrical contact B would be potentially compliant.

Subsequently, it has been carried out a temperature test according to the reference specification CEI 23-50 article 19, which has further confirmed the results of the method according to the present invention, diagnosing that the first contact A was not compliant, as previously verified by means of the minimum extraction force test.

The method according to the invention has been tested in alternate current condition and preliminarily in direct current.

In the method according to the invention, therefore, for a general electrical contact, after a first measured resistance, a stress is applied to the electrical contact, for example a current pulse, so as to test the consequent variation of its resistance. In fact, a third resistance is measured after applying the stress to the electrical contact, so as to test the gradient resistance of the same electrical contact and evaluate a possible non-compliance of the same in case, surprisingly, a negative gradient is observed.

Thus, it has experimentally been proved a strong correlation between the state of the electrical contacts and the value of the resistance gradient found. In particular, negative gradient values, that is a third resistance Rt3 lower than the first resistance Rt1, show a lower quality of the electrical contact when compared to samples having positive gradient or a substantially constant resistance.

It is therefore observed a surprising effect that clashes against the technical prejudice according to which the expected behaviour of electrical contacts tested should be as follows.

Based on the two Ohm's laws, on Joule's law and on the trend of the thermal coefficient of the resistivity of metals, it should experimentally be seen that an electrical contact should increase its resistance as its temperature increases due to the Joule's effect when the current flows through it.

As regards Joule's Law, according to the "Enciclopedia della Scienza e della Tecnica" published by De Agostini - Novara, 1995 edition (hereinafter "De Agostini") at page 631: "Joule, effect, phenomenon because of which the passage of electrical current through a conductor develops heat, which originates at the expense of the electrical energy and which has as a consequence the heating up of the conductor. The heat produced for J's. e. in a time t is expressed by Joule's law (formulated by the English physicist J. P. Joule, 1818-89), Q=Ri²t where R is the resistance of the conductor and i the intensity of the current which flows through it". A similar definition of Joule's effect can also be found for example in the "Enciclopedia della Scienza e della Tecnica Mondadori-McGraw-Hill" by Arnoldo Mondadori Publishing - Milan, VII edition of June 1980 (hereinafter "Mondadori") at page 502.

As regards resistivity, at page 898 of "De Agostini" it can be read: "resistivity, quantity showing the aptitude of metals to conduct electrical current, referred to a body having unitary cross-section and length ... resistivity has the symbol p and it increases with temperature according to the relation ρₜ = ρ₂₀[1 + α₂₀(t - 20)] where ρₜ is resistivity at the temperature t, ρ₂₀ is resistivity at 20°C and α₂₀ is the temperature coefficient at 20°C". A similar definition of resistivity can also be found for example in "Mondadori" at page 741.

These definitions and the first Ohm's law on electrical resistance, together with the second Ohm's law on resistivity are well known to a person skilled in the art and described in the reference texts of the sector.

An increase of the temperature, due to the Joule's effect then causes a flawed electrical contact to heat up more with respect to an efficient electrical contact the current being the same, as, in fact, it has been applied in the temperature tests and previously described.

Furthermore, the presence of temperature tests, which have very long execution times, employed as type tests, show the development of the known technique in a direction which is different with respect to the test method according to the invention, which, on the contrary, advantageously is short and non destructive, since, the electrical contacts that have been evaluated as compliant by means of the method according to the invention have subsequently been evaluated as compliant also by means of the method of the temperature test and many others.

Conveniently, it has been referred to the electrical stresses obtained by the variation of the current or current intensity, as for example shown in figure 4, to which the electrical contact to be evaluated is subjected, but it is of course understood that what herewith described is applicable for similar variations of voltage or of instantaneous electrical power to which the electrical contact is subjected.

A method according to the invention for carrying out electrical testing of an electrical contact, therefore comprises the following steps:
a. measuring a first resistance of the electrical contact while it is subjected to a first instantaneous electric power in a first time;
b. subjecting the electrical contact to an electric stress in a second time following the first time so that said electric contact has a second resistance while it is subjected to a second instantaneous electric power;
c. measuring a third resistance of the electrical contact while it is subjected to a third instantaneous electric power for a third time, following the second time;
d. evaluating the state of the electrical contact according to the difference between the value of the third resistance measured in step c. and the first resistance measured in step a.

Preferably, the electrical stress can be a predetermined variation of instantaneous electric power to which the electrical contact is subjected, said variation being maintained for a predetermined time interval.

Advantageously, if the difference between the value of the third measured resistance and the first measured resistance is negative the electrical contact is evaluated as inadequate or probably non compliant, that is when the value of the third measured resistance is lower than the value of the first measured resistance.

Preferably, the stress can be a pulse having a substantially vertical ramp and/or a square pulse waveform.

Advantageously, the electric current employed is alternate current.

Preferably, the resistance measurements are obtained indirectly by measuring voltage drops by means of the electrical measuring device M electrically coupled to a first end and to a second end of the respective electrical contact to be evaluated.

Advantageously, the steps from a. to d. are performed at first on one of the electrical contacts and in a second time on another electrical contact, so as to evaluate them independently of each other.

Therefore, the method according to the invention has many advantages, that is a great speed of execution, non destructivity towards compliant electrical contacts, as well as a very clear evidence which is easy to measure and to compare.

The method according to the present invention is applicable in many fields:
- as type test of electrical contact, when one or more regulations acknowledge it;
- as a routine test, when one or more regulations acknowledge it;
- as a quality test of a product;
- as a method to test the correct assembly of an electrical product;
- as a method to test the correct assembly of a distribution line of electric energy;
- as a method to test the operating/maintenance state of an electrical system;
- other applications when it is necessary to test and maintain electrical contacts.

Advantageously, such method with differential measurement can comprise an evaluation on the first measurement of the resistance of the electrical contact in the first time and its evaluation with a predetermined threshold resistance, so as to obtain a more complete evaluation of the efficiency of the electrical contact being evaluated. An example of a predetermined threshold resistance is the measurement of a resistance of an electrical contact which has been tested as compliant by means of the method according to the invention or other tests according to the prior art.

Furthermore, it can be evaluated a first electrical contact comprising a first element coupled to a first coupling and subsequently, after having decoupled the first coupling from the first element, it is possible to evaluate one or more second electrical contacts comprising one or more second elements coupled to the first coupling, so that it is possible to measure directly the differences between the first element and the one or more second elements as said first element and said one or more second elements are respectively coupled with the first coupling in successive time intervals.

Furthermore, all the objects and advantages are achieved by an apparatus to perform the electrical test of one or more electrical contacts comprising two ends according to a method according to the present invention, said apparatus comprising:
- an electric generator electrically couplable to the one or more electrical contacts and adapted to provide electric energy to said one or more electrical contacts;
- an electrical measuring device electrically couplable to the one or more electrical contacts and adapted to measure the resistance of said one or more electrical contacts;
- one or more terminals which are electrically coupled with the electrical generator and with the electrical measuring device and which are removably couplable with one or more ends of the one or more electrical contacts to be evaluated.

Advantageously, in order to evaluate one or more electrical contacts, the one or more terminals can be removably couplable with one or more ends of the one or more electrical contacts to evaluate, so as to be able to evaluate at different times at least another one of the two or more electrical contacts when said one or more terminals are subsequently coupled with one or more ends of said another one of the two or more electrical contacts.

An electrical apparatus to perform the method according to the invention can advantageously comprise means for moving the first coupling 12A or similar coupling, for example a mechanism for moving the first coupling 12A and for coupling or decoupling the first coupling 12A with the first element 10A and the second element 10B at successive time intervals. An example of mechanism may be a revolver-like mechanism, known *per se,* or a shifting or rotary mechanism or many more. Of course, the present invention can have a great number of applications, modifications or alternatives without exiting the scope of the invention as defined by the independent claim 1.

Further, the materials and equipment used for the embodiment of the present invention, as well as the forms and dimensions of individual components, will be the most suitable according to specific requirements.

## Claims

1. Method for carrying out an electrical test to be used in a non-destructive way for the evaluation of electrical contacts or for their maintenance, comprising the following steps:
a) measuring a first resistance (Rt1) of the electrical contact (A;B) while it is subjected to a first instantaneous electric power in a first time (t1);
b) subjecting the electrical contact (A;B) to an electric stress (S1) in a second time (t2) following the first time (t1), so that said electric contact (A;B) has a second resistance (Rt2) while it is subjected to a second instantaneous electric power;
c) measuring a third resistance (Rt3) of the electrical contact (A;B) while it is subjected to a third instantaneous electric power for a third time (t3), following the second time (t2);
d) evaluating the state of the electrical contact (A;B) according to the difference between the value of the third resistance (Rt3) measured in step c) and the first resistance (Rt1) measured in step a).

2. Method according to claim 1, wherein the electric stress (S1) is a variation of instantaneous electric power having the shape of a peak (P) and having an intensity peak equal to the second instantaneous electric power, said second instantaneous electric power being greater than the first instantaneous electric power.

3. Method according to claim 1, wherein the electric stress (S1) is a variation of instantaneous electric power having the form of a pulse of instantaneous electric power having a substantially vertical ramp and an intensity peak equal to the second instantaneous electric power, said second instantaneous electric power being greater than the first instantaneous electric power.

4. Method according to claim 1, wherein the electric stress (S1) is a variation of instantaneous electric power having the shape of a rectangular pulse (Q) and an intensity peak equal to the second instantaneous electric power, said second instantaneous electric power being greater than the first instantaneous electric power.

5. Method according to any one of the preceding claims, wherein the electrical stress (S1) applied in the second time (t2) is maintained for a time interval of less than 2 seconds.

6. Method according to any one of the preceding claims, wherein at least one between the first instantaneous electric power and the third instantaneous electric power is equal to a predetermined instantaneous electric power, equal to a nominal instantaneous electric power for which the electric contact (A;B) is designed.

7. Method according to any one of the preceding claims, in which the second instantaneous electric power is higher than the first instantaneous electric power, preferably higher than at least twice the first instantaneous electric power.

8. Method according to any one of the preceding claims, wherein the electrical stress (S1) is a predetermined variation of instantaneous electric power to which the electrical contact (A;B) is subjected, said variation being obtained by a variation of at least one between the voltage and the current intensity (11,12,13) to which is subjected the electrical contact (A;B).

9. Method according to any one of the preceding claims, in which at the step d) the electrical contact (A;B) is evaluated not adequate in the case in which it is found that the value of the third resistance (Rt3) measured is less than the value of the first resistance (Rt1) measured.

10. Method for carrying out the electrical test of at least two electrical contacts (A;B) according to any one of the preceding claims, wherein the steps from a) to d) are performed at first on one (A) of the at least two electrical contacts and in at least a second time on another (B) of the at least two electrical contacts, so as to evaluate them independently of each other.

11. A method according to the preceding claim, in which is evaluated a first electric contact (A) comprising a first element (10A) coupled to a first coupling (12A) and subsequently at least a second electrical contact (B) comprising at least a second element (10B) coupled to at least a second coupling (12B).

12. Method according to claim 10 or 11, in which is evaluated a first electric contact (A) comprising a first element (10A) coupled to a first coupling (12A) and subsequently, after having decoupled the first coupling (12A) from the first element (1 0A), is evaluated at least a second electrical contact (B) comprising at least a second element (10B) coupled to the first coupling (12A), so that it is possible to measure directly the differences between the first element (10A) and the at least a second element (10B), as the said first element (10A) and said at least a second element (10B) are respectively coupled in successive time intervals with the first coupling (12A).

13. A method according to any one of the preceding claims, in which the resistance measurements are obtained indirectly from measurements of the voltage drop by means of an electrical measuring device (M) electrically coupled to a first end and a second end of the at least one electrical contact (A;B).

14. Apparatus (100;110) for carrying out an electrical test to be used in a non-destructive way for the evaluation of electrical contacts or for their maintenance, comprising at least two ends according to a method according to any one of the preceding claims, said apparatus (100;110) comprising:
- An electric generator (G) electrically coupled to the at least one electrical contact (A;B) and adapted to provide electrical energy to said at least one electrical contact (A;B);
- An electrical measuring device (M) electrically coupled to the at least one electrical contact (A;B) and adapted to measure the resistance of said at least one electrical contact (A;B);
- At least one terminal (C;E) which is electrically coupled with the electrical generator (G) and with the electrical measuring device (M) and which is removably couplable with at least one end of the at least one electrical contact (A;B) to be evaluated.

15. Apparatus (100;110) according to the previous claim, to perform the electrical test of at least two electrical contacts (A;B) according to a method according to any one of claims 1 to 13, wherein:
- the at least one terminal (C;E) is removably couplable with at least one end of one (A) of the at least two electrical contacts to be evaluated, so as to evaluate at different times at least one other (B) of the at least two electrical contacts when said at least one terminal (C;E) is subsequently coupled with at least one end of said another one (B) of the at least two electrical contacts.

16. Apparatus (100;110) according to the preceding claim, for evaluating a first element (10A) and at least a second element (10B) of at least two electrical contacts (A;B), wherein said apparatus (100;110 ) comprises a first coupling (12A) adapted to be coupled to said first element (10A) or said at least one second element (10B) at different times and subsequent, and
wherein said apparatus (100;110) comprises a mechanism for moving the first coupling (12A) and to couple or decouple the first coupling (12A) with said first element (10A) and said at least a second element (10B) at intervals of successive time.

## Patentansprüche

1. Verfahren zum Ausführen eines elektrischen Tests, der zerstörungsfrei für die Bewertung von elektrischen Kontakten oder für deren Wartung eingesetzt werden kann, umfassend die folgenden Schritte:
a) Messen eines ersten Widerstandes (Rt1) des elektrischen Kontaktes (A;B), während er in einer ersten Zeit (t1) einer ersten momentanen elektrischen Leistung ausgesetzt ist;
b) Einwirkenlassen einer elektrischen Beanspruchung (S1) auf den elektrischen Kontakt (A;B) in einer auf die erste Zeit (t1) folgenden zweiten Zeit (t2), so dass der elektrische Kontakt (A; B) einen zweiten Widerstand (Rt2) hat, während er einer zweiten momentanen elektrischen Leistung ausgesetzt ist;
c) Messen eines dritten Widerstandes (Rt3) des elektrischen Kontaktes (A;B), während er über eine auf die zweite Zeit (t2) folgende dritte Zeit (t3) einer dritten momentanen elektrischen Leistung ausgesetzt ist;
d) Bewerten des Zustandes des elektrischen Kontaktes (A;B) entsprechend der Differenz zwischen dem Wert des in Schritt c) gemessenen dritten Widerstandes (Rt3) und dem in Schritt a) gemessenen ersten Widerstand (Rt1).

2. Verfahren nach Anspruch 1, wobei die elektrische Beanspruchung (S1) eine Änderung momentaner elektrischer Leistung ist, die die Form einer Spitze (P) hat und eine Intensitäts-Spitze aufweist, die der zweiten momentanen elektrischen Leistung gleich ist, wobei die zweite momentane elektrische Leistung größer ist als die erste momentane elektrische Leistung.

3. Verfahren nach Anspruch 1, wobei die elektrische Beanspruchung (S1) eine Änderung momentaner elektrischer Leistung ist, die die Form eines Impulses momentaner elektrischer Leistung mit einer im Wesentlichen vertikalen Rampe und einer Intensitäts-Spitze hat, die der zweiten momentanen elektrischen Leistung gleich ist, wobei die zweite momentane elektrische Leistung größer ist als die erste momentane elektrische Leistung.

4. Verfahren nach Anspruch 1, wobei die elektrische Beanspruchung (S1) eine Änderung momentaner elektrischer Leistung ist, die die Form eines Rechteckimpulses (Q) und eine Intensitäts-Spitze hat, die der zweiten momentanen elektrischen Leistung gleich ist, wobei die zweite momentane elektrische Leistung größer ist als die erste momentane elektrische Leistung.

5. Verfahren nach einem der vorangehenden Ansprüche, wobei die in der zweiten Zeit (t2) wirkende elektrische Beanspruchung (S1) über ein Zeitintervall von weniger als 2 Sekunden aufrechterhalten wird.

6. Verfahren nach einem der vorangehenden Ansprüche, wobei die erste momentane elektrische Leistung oder/und die dritte momentane elektrische Leistung einer vorgegebenen momentanen elektrischen Leistung gleich ist, die einer nominellen momentanen elektrischen Leistung gleich ist, für die der elektrische Kontakt (A;B) ausgelegt ist.

7. Verfahren nach einem der vorangehenden Ansprüche, wobei die zweite momentane elektrische Leistung höher ist als die erste momentane elektrische Leistung, vorzugsweise höher als wenigstens das Doppelte der ersten momentanen elektrischen Leistung.

8. Verfahren nach einem der vorangehenden Ansprüche, wobei die elektrische Belastung (S1) eine vorgegebene Änderung momentaner elektrischer Leistung ist, der der elektrische Kontakt (A;B) ausgesetzt ist, und sich die Änderung durch eine Änderung der Spannung oder/und der Stromstärke (11, 12, 13) ergibt, denen der elektrische Kontakt (A; B) ausgesetzt ist.

9. Verfahren nach einem der vorangehenden Ansprüche, wobei in dem Schritt d) der elektrische Kontakt (A;B) dann als nicht geeignet bewertet wird, wenn festgestellt wird, dass der Wert des gemessenen dritten Widerstandes (Rt3) kleiner ist als der Wert des gemessenen ersten Widerstandes (Rt1).

10. Verfahren zum Ausführen des elektrischen Tests wenigstens zweier elektrischer Kontakte (A; B) nach einem der vorangehenden Ansprüche, wobei die Schritte von a) bis d) zunächst an einem (A) der wenigstens zwei elektrischen Kontakte und in wenigstens einer zweiten Zeit an einem anderen (B) der wenigstens zwei elektrischen Kontakte durchgeführt werden, um sie unabhängig voneinander zu bewerten.

11. Verfahren nach dem vorangehenden Anspruch, wobei ein erster elektrischer Kontakt (A), der ein erstes Element (10A) umfasst, das mit einer ersten Kupplung (12A) gekoppelt ist, und anschließend wenigstens ein zweiter elektrischer Kontakt (B) bewertet werden, der wenigstens ein zweites Element (10B) umfasst, das mit wenigstens einer zweiten Kupplung (12B) gekoppelt ist.

12. Verfahren nach Anspruch 10 oder 11, wobei ein erster elektrischer Kontakt (A) bewertet wird, der ein erstes Element (10A) umfasst, das mit einer ersten Kupplung (12A) gekoppelt ist, und anschließend, nachdem die erste Kupplung (12A) von dem ersten Element (10A) entkoppelt worden ist, wenigstens ein zweiter elektrischer Kontakt (B) bewertet wird, der wenigstens ein zweites Element (10B) umfasst, das mit der ersten Kupplung (12A) gekoppelt ist, so dass es möglich ist, direkt die Unterschiede zwischen dem ersten Element (10A) und dem wenigstens einen zweiten Element (10B) zu messen, da das erste Element (10A) und das wenigstens eine zweite Element (10B) jeweils in aufeinanderfolgenden Zeitintervallen mit der ersten Kopplung (12A) gekoppelt sind.

13. Verfahren nach einem der vorangehenden Ansprüche, wobei die Widerstandsmessungen indirekt anhand von Messungen des Spannungsgefälles mittels einer elektrischen Messvorrichtung (M) gewonnen werden, die elektrisch mit einem ersten Ende und einem zweiten Ende des wenigstens einen elektrischen Kontaktes (A;B) gekoppelt ist.

14. Vorrichtung (100; 110) zum Ausführen eines elektrischen Tests, der zerstörungsfrei für die Bewertung elektrischer Kontakte oder für deren Wartung eingesetzt werden kann, umfassend wenigstens zwei Enden, gemäß einem Verfahren nach einem der vorangehenden Ansprüche, wobei die Vorrichtung (100; 110) umfasst:
einen elektrischen Generator (G), der elektrisch mit dem wenigstens einen elektrischen Kontakt (A;B) gekoppelt und so eingerichtet ist, dass er dem wenigstens einen elektrischen Kontakt (A;B) elektrische Energie zuführt;
eine elektrische Messvorrichtung (M), die elektrisch mit dem wenigstens einen elektrischen Kontakt (A;B) gekoppelt und so eingerichtet ist, dass sie den Widerstand des wenigstens einen elektrischen Kontaktes (A;B) misst;
wenigstens einen Anschluss (C;E), der elektrisch mit dem elektrischen Generator (G) sowie mit der elektrischen Messeinrichtung (M) gekoppelt ist und der lösbar mit wenigstens einem Ende des wenigstens einen zu bewertenden elektrischen Kontaktes (A;B) gekoppelt werden kann.

15. Vorrichtung (100; 110) nach dem vorangehenden Anspruch zum Durchführen des elektrischen Tests wenigstens zweier elektrischer Kontakte (A;B) gemäß einem Verfahren nach einem der Ansprüche 1 bis 13, wobei:
der wenigstens eine Anschluss (C;E) lösbar mit wenigstens einem Ende eines (A) der wenigstens zwei zu bewertenden elektrischen Kontakte gekoppelt werden kann, um zu verschiedenen Zeiten wenigstens einen anderen (B) der wenigstens zwei elektrischen Kontakte zu bewerten, wenn der wenigstens eine Anschluss (C;E) anschließend mit wenigstens einem Ende des anderen (B) der wenigstens zwei elektrischen Kontakte gekoppelt wird.

16. Vorrichtung (100;110) nach dem vorangehenden Anspruch zum Bewerten eines ersten Elementes (10A) und wenigstens eines zweiten Elementes (10B) wenigstens zweier elektrischer Kontakte (A;B), wobei die Vorrichtung (100;110) eine erste Kopplung (12A) umfasst, die so eingerichtet ist, dass sie zu unterschiedlichen Zeiten und aufeinanderfolgend mit dem ersten Element (10A) oder dem wenigstens einen zweiten Element (10B) gekoppelt wird, und
wobei die Vorrichtung (100;110) einen Mechanismus zum Bewegen der ersten Kupplung (12A) und zum Koppeln oder Entkoppeln der ersten Kupplung (12A) mit/von dem ersten Element (10A) und dem wenigstens einen zweiten Element (10B) in aufeinanderfolgenden Zeitintervallen umfasst.

## Revendications

1. Procédé pour effectuer un test électrique non destructif dans l'évaluation de contacts électrique ou pour leur maintenance, comprenant les étapes suivantes :
a) mesurer une première résistance (Rt1) du contact électrique (A ; B) alors qu'il est soumis à une première puissance électrique instantanée dans un premier temps (t1) ;
b) soumettre le contact électrique (A ; B) à une contrainte électrique (S1) dans un second temps (t2) suivant le premier temps (t1), de sorte que ledit contact électrique (A ; B) présente une seconde résistance (Rt2) tandis qu'il est soumis à une seconde puissance électrique instantanée ;
c) mesurer une troisième résistance (Rt3) du contact électrique (A ; B) alors qu'il est soumis à une troisième puissance électrique instantanée dans un troisième temps (t3), suivant le second temps (t2) ;
d) évaluer l'état du contact électrique (A ; B) en fonction de la différence entre la valeur de la troisième résistance (Rt3) mesurée à l'étape c) et la première résistance (Rt1) mesurée à l'étape a).

2. Procédé selon la revendication 1, dans lequel la contrainte électrique (S1) est une variation de puissance électrique instantanée ayant la forme d'un pic (P) et ayant un pic d'intensité égal à la seconde puissance électrique instantanée, ladite seconde puissance électrique instantanée étant supérieure à la première puissance électrique instantanée.

3. Procédé selon la revendication 1, dans lequel la contrainte électrique (S1) est une variation de puissance électrique instantanée ayant la forme d'une impulsion de puissance électrique instantanée ayant une rampe sensiblement verticale et un pic d'intensité égal à la seconde puissance électrique instantanée, ladite seconde puissance électrique instantanée étant supérieure à la première puissance électrique instantanée.

4. Procédé selon la revendication 1, dans lequel la contrainte électrique (S1) est une variation de puissance électrique instantanée ayant la forme d'une impulsion rectangulaire (Q) et un pic d'intensité égal à la seconde puissance électrique instantanée, ladite seconde puissance électrique instantanée étant supérieure à la première puissance électrique instantanée.

5. Procédé selon l'une quelconque des revendications précédentes, dans lequel la contrainte électrique (S1) appliquée dans le second temps (t2) est maintenue pendant un intervalle de temps inférieur à 2 secondes.

6. Procédé selon l'une quelconque des revendications précédentes, dans lequel au moins l'une de la première puissance électrique instantanée et de la troisième puissance électrique instantanée est égale à une puissance électrique instantanée prédéterminée, égale à une puissance électrique instantanée nominale pour laquelle le contact électrique (A ; B) est conçu.

7. Procédé selon l'une quelconque des revendications précédentes, dans lequel la seconde puissance électrique instantanée est supérieure à la première puissance électrique instantanée, de préférence supérieure à au moins deux fois la première puissance électrique instantanée.

8. Procédé selon l'une quelconque des revendications précédentes, dans lequel la contrainte électrique (S1) est une variation prédéterminée de puissance électrique instantanée à laquelle est soumis le contact électrique (A ; B), ladite variation étant obtenue par une variation d'au moins l'une de la tension et de l'intensité du courant (I1,I2,I3) auxquelles est soumis le contact électrique (A ; B).

9. Procédé selon l'une quelconque des revendications précédentes, dans lequel à l'étape d) le contact électrique (A ; B) est évalué non adéquat dans le cas où l'on constate que la valeur de la troisième résistance (Rt3) mesurée est inférieure à la valeur de la première résistance (Rt1) mesurée.

10. Procédé pour effectuer le test électrique d'au moins deux contacts électriques (A ; B) selon l'une quelconque des revendications précédentes, dans lequel les étapes de a) à d) sont réalisées d'abord sur l'un (A) des au moins deux contacts électriques et dans au moins un second temps sur un autre (B) des au moins deux contacts électriques, de manière à les évaluer indépendamment l'un de l'autre.

11. Procédé selon la revendication précédente, dans lequel on évalue un premier contact électrique (A) comprenant un premier élément (10A) couplé à un premier couplage (12A) et ensuite au moins un second contact électrique (B) comprenant au moins un second élément (10B) couplé à au moins un second couplage (12B).

12. Procédé selon la revendication 10 ou 11, dans lequel on évalue un premier contact électrique (A) comprenant un premier élément (10A) couplé à un premier couplage (12A) et ensuite, après avoir découplé le premier couplage (12A) du premier élément (10A), on évalue au moins un second contact électrique (B) comprenant au moins un second élément (10B) couplé au premier couplage (12A), de sorte qu'il est possible de mesurer directement les différences entre le premier élément (10A ) et le au moins un second élément (10B), alors que ledit premier élément (10A) et ledit au moins un second élément (10B) sont respectivement couplés à des intervalles de temps successifs au premier couplage (12A).

13. Procédé selon l'une quelconque des revendications précédentes, dans lequel les mesures de résistance sont obtenues indirectement à partir de mesures de la chute de tension au moyen d'un dispositif de mesure électrique (M) couplé électriquement à une première extrémité et à une seconde extrémité du au moins un contact électrique (A ; B) .

14. Appareil (100 ; 110) destiné à effectuer un test électrique d'une manière non destructive dans l'évaluation de contacts électrique ou pour leur maintenance, comprenant au moins deux extrémités selon un procédé selon l'une quelconque des revendications précédentes, ledit appareil (100 ; 110) comprenant :
- un générateur électrique (G) couplé électriquement au au moins un contact électrique (A ; B) et adapté pour fournir de l'énergie électrique audit au moins un contact électrique (A ; B) ;
- un dispositif (M) de mesure électrique couplé électriquement au au moins un contact électrique (A ; B) et adapté pour mesurer la résistance dudit au moins un contact électrique (A ; B) ;
- au moins une borne (C ; E) qui est couplée électriquement au générateur électrique (G) et au dispositif (M) de mesure électrique et qui peut être couplée de manière réversible à au moins une extrémité du au moins un contact électrique (A ; B) à évaluer.

15. Appareil (100 ; 110) selon la revendication précédente, destiné à effectuer le test électrique d'au moins deux contacts électriques (A ; B) selon un procédé selon l'une quelconque des revendications 1 à 13, dans lequel :
- la au moins une borne (C ; E) peut être couplée de manière réversible à au moins une extrémité de l'un (A) des au moins deux contacts électriques à évaluer, de manière à évaluer à des instants différents au moins un autre (B) des au moins deux contacts électriques lorsque ladite au moins une borne (C ; E) est ensuite couplée à au moins une extrémité dudit autre (B) des au moins deux contacts électriques.

16. Appareil (100 ; 110) selon la revendication précédente, destiné à évaluer un premier élément (10A) et au moins un second élément (10B) d'au moins deux contacts électriques (A ; B), dans lequel ledit appareil (100 ; 110) comprend un premier couplage (12A) adapté à être couplé audit premier élément (10A) ou audit au moins un second élément (10B) à des instants différents et ultérieurs, et
dans lequel ledit appareil (100 ; 110) comprend un mécanisme pour déplacer le premier couplage (12A) et pour coupler ou découpler le premier couplage (12A) audit premier élément (10A) et audit au moins un second élément (10B) à des intervalles de temps successifs.
